# FASCICULE DE BREVET EUROPEEN

(11) **EP 2 267 772 B1**
(45) Date de publication et mention de la délivrance du brevet: **29.07.2015**
(21) Numéro de dépôt: 10163673.6
(22) Date de dépôt: 21.05.2010
(51) Int. Cl.: G06K 19/073, H01L 21/66, H01L 23/00, G01L 9/00

(54) **Circuit de détection d'amincissement du substrat d'une puce de circuit intégré**
Schaltung zur Erkennung der Verdünnung des Substrats eines Chips mit integriertem Schaltkreis
Circuit for detecting thinning of the substrate of an integrated circuit chip

(30) Priorité: 15.06.2009 FR 0953968
(43) Date de publication de la demande: 29.12.2010
(73) Titulaire: STMicroelectronics (Rousset) SAS, 13790 Rousset (FR)
(72) Inventeur: Fornara, Pascal, 83910 Pourrieres (FR); Rivero, Christian, 13080 Luynes (FR)
(74) Mandataire: de Beaumont, Michel

(56) Documents cités:
- EP-A- 1 691 413
- US-A- 4 016 644
- US-A- 5 060 261
- JEFFREY C SUHLING ET AL: "Silicon Piezoresistive Stress Sensors and Their Application in Electronic Packaging" IEEE SENSORS JOURNAL, IEEE SERVICE CENTER, NEW YORK, NY, US, vol. 1, no. 1, 1 juin 2001 (2001-06-01), pages 14-30, XP011055568 ISSN: 1530-437X
- KASBARI M ET AL: "Embedded Stress Sensors for Strained Technologies Process Control" IEEE TRANSACTIONS ON SEMICONDUCTOR MANUFACTURING, IEEE SERVICE CENTER, PISCATAWAY, NJ, US, vol. 21, no. 3, 1 août 2008 (2008-08-01), pages 352-357, XP011232426 ISSN: 0894-6507
- KANDA Y: "A GRAPHICAL REPRESENTATION OF THE PIEZORESISTANCE COEFFICIENTS IN SILICON" IEEE TRANSACTIONS ON ELECTRON DEVICES, IEEE SERVICE CENTER, PISACATAWAY, NJ, US, vol. ED-29, no. 1, 1 janvier 1982 (1982-01-01), pages 64-70, XP000673850 ISSN: 0018-9383

## Description

### Domaine de l'invention

La présente invention concerne la protection d'une puce de circuit intégré contre des attaques laser. Elle vise plus particulièrement la détection de l'amincissement du substrat de la puce qui doit être réalisé avant d'effectuer une attaque laser.

### Exposé de l'art antérieur

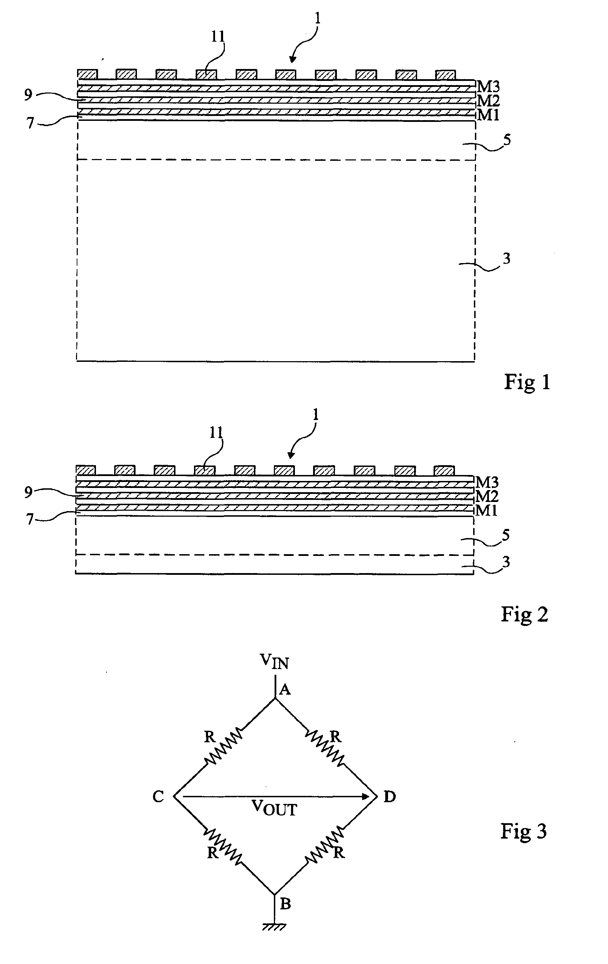

La figure 1 est une vue en coupe schématique d'une puce de circuit intégré 1 comportant un substrat semiconducteur de support 3, comportant dans sa partie supérieure une couche active 5 dans laquelle sont réalisés des composants électroniques non représentés. De façon courante, le substrat 3 est recouvert d'un empilement de couches isolantes 7. Des pistes conductrices d'interconnexion 9 sont formées entre les couches isolantes. Il existe généralement plusieurs niveaux d'interconnexion successifs, trois, M1 à M3, dans l'exemple représenté. Des vias conducteurs non représentés traversent les couches isolantes pour relier les pistes conductrices entre elles, à des bornes 11 d'entrée-sortie de la puce, et à des composants de la couche active 5, réalisant ainsi les interconnexions du circuit.

Dans les dispositifs sécurisés, par exemple des cartes de paiement, certaines régions de la zone active 5 sont susceptibles de traiter et/ou de stocker des données sensibles, par exemple des clés de chiffrement. De tels dispositifs peuvent faire l'objet de manipulations frauduleuses visant à obtenir des informations confidentielles protégées.

Parmi les attaques connues, les attaques dites "attaques par faute", consistent à perturber volontairement le fonctionnement d'une puce, et à analyser l'influence des perturbations sur son comportement. L'attaquant s'intéresse notamment à l'influence des perturbations sur des données telles que des signaux de sortie, la consommation, ou des temps de réponse. Il est susceptible d'en déduire, par des études statistiques ou autres, des informations sensibles telles que les algorithmes utilisés et éventuellement des clés de chiffrement. Pour provoquer volontairement des anomalies dans les circuits d'une puce, un mode d'attaque consiste à bombarder des zones de la puce par un faisceau laser. On peut ainsi injecter des fautes dans certaines cellules mémoires et/ou affecter le comportement de certains composants. On notera que lors d'une attaque laser, la puce doit être alimentée.

La figure 2 est une vue en coupe schématique de la puce 1 de la figure 1 illustrant une étape préliminaire d'amincissement du substrat 3, nécessaire à la réalisation d'une attaque laser. Pour rendre accessible au faisceau laser les composants de la région active 5, l'attaquant doit retirer une partie de l'épaisseur du substrat de support 3. A titre d'exemple, une puce formée à partir d'un substrat de 180 µm d'épaisseur subira une diminution d'épaisseur de l'ordre de 150 µm avant une attaque laser.

Pour se prémunir contre les fraudes, il est généralement prévu dans les puces sécurisées un dispositif de détection d'attaque, couplé à un circuit de protection. Lorsqu'une attaque est détectée, le circuit de protection met en oeuvre des mesures de protection, d'aliénation, ou de destruction des données sensibles. Par exemple, on pourra prévoir, lorsqu'une attaque est détectée, d'interrompre l'alimentation de la puce ou de provoquer sa réinitialisation, de façon à minimiser le temps pendant lequel l'attaquant peut étudier la réponse de la puce à une perturbation.

Les solutions de détection d'attaque peuvent être logiques. Elles consistent par exemple à introduire régulièrement dans les calculs des tests d'intégrité permettant de s'assurer que les données n'ont pas été modifiées par l'extérieur. Ces solutions présentent l'inconvénient d'introduire des étapes de calcul supplémentaires, augmentant ainsi les temps de réponse de la puce. En outre, les tests d'intégrité ne peuvent pas détecter toutes les perturbations provoquées par un attaquant. Ce dernier dispose donc d'une certaine marge de manoeuvre susceptible de lui permettre d'acquérir des informations sensibles.

D'autres solutions de détection d'attaque, dites physiques, comportent notamment des capteurs sensibles aux variations de température, aux ultraviolets, ou aux rayons X, permettant de déceler des activités suspectes. De même que les solutions logiques, ces solutions ne sont pas parfaitement fiables. En effet, l'attaquant dispose d'une marge de manoeuvre avant la détection de l'attaque, susceptible de lui permettre d'obtenir des informations sensibles. En outre, ces solutions sont chères et difficiles à mettre en oeuvre.

Un autre dispositif de protection d'une puce est décrit dans la demande de brevet européen EP1691413, comprenant des régions diffusées du côté de la face arrière du substrat. Le retrait de ces régions diffusées lors de l'amincissement du substrat provoque un dysfonctionnement de la puce.

Les articles "Silicon Piezoresistive Stress Sensors and Their Application in Electronic Packaging" (Jeffrey - IEEE Sensors journal, VOL.1, N°1, Juin 2001) et "Embedded Stress Sensors for Strained Technologies Process Control" (IEEE Transactions on semiconductor manufacturing, VLO.21, N°3, aout 2008) décrivent des dispositifs de mesure du stress dans une puce de circuit intégré, et le brevet US4016644 décrit un capteur de pression.

### Résumé

Ainsi, un objet d'un mode de réalisation de la présente invention est de proposer un circuit de détection d'une attaque laser palliant au moins certains des inconvénients des solutions de l'art antérieur.

Un objet d'un mode de réalisation de la présente invention est de proposer un circuit permettant la détection de l'attaque avant que l'attaquant ne soit en mesure d'analyser la réponse de la puce à des perturbations laser.

Un objet d'un mode de réalisation de la présente invention est de détecter l'amincissement du substrat de support de la puce, qui doit nécessairement être réalisé avant d'effectuer une attaque laser.

Un objet d'un mode de réalisation de la présente invention est de proposer une solution à faible coût et facile à réaliser avec les procédés de fabrication usuels.

La présente invention est définie par un circuit selon la revendication 1.

Ainsi, la présente invention prévoit un dispositif de détection d'amincissement du substrat d'une puce de circuit intégré, comportant, dans la couche active du substrat, des résistances diffusées en forme de barreaux reliées en un pont de Wheatstone, dans lequel : des premières résistances opposées du pont sont orientées selon une première direction ; les secondes résistances opposées du pont sont orientées selon une seconde direction ; et les première et seconde directions sont telles qu'un amincissement du substrat entraine une variation de la valeur de déséquilibre du pont.

Selon un mode de réalisation de la présente invention, les faces principales du substrat sont dans le plan [001] de la structure cristalline du substrat.

Selon un mode de réalisation de la présente invention : les résistances diffusées sont formées dans une région du substrat d'un premier type de conductivité ; et les première et seconde directions correspondent respectivement aux directions (100) et (110) de la structure cristalline du substrat.

Selon un mode de réalisation de la présente invention : les premières résistances opposées sont formées dans une région du substrat d'un premier type de conductivité ; lesdites secondes résistances opposées sont formées dans une région du substrat du second type de conductivité ; et les première et seconde directions correspondent respectivement aux directions (100) et (010) de la structure cristalline du substrat.

Selon un mode de réalisation de la présente invention : les premières résistances opposées sont formées dans une région du substrat d'un premier type de conductivité ; les secondes résistances opposées sont formées dans une région du substrat du second type de conductivité ; et les première et seconde directions sont parallèles à la direction (110) de la structure cristalline du substrat.

Selon un mode de réalisation de la présente invention : les résistances diffusées sont formées dans une région du substrat dopée de type P ; les première et seconde directions correspondent respectivement aux directions (100) et (110) de la structure cristalline du substrat ; et les secondes résistances opposées sont chacune entourées d'une région d'isolement recouverte d'une couche de silicium polycristallin, l'ensemble de la résistance étant recouvert d'une couche de nitrure de protection.

Selon un mode de réalisation de la présente invention : les résistances diffusées sont formées dans une région du substrat dopée de type N ; les première et seconde directions correspondent respectivement aux directions (100) et (110) de la structure cristalline du substrat ; et les premières résistances opposées sont chacune entourées d'une région d'isolement recouverte d'une couche de silicium polycristallin, l'ensemble de la résistance étant recouvert d'une couche de nitrure de protection.

La présente invention prévoit un circuit de détection d'amincissement du substrat d'une puce de circuit intégré comportant : au moins un dispositif de détection d'amincissement du substrat selon l'un quelconque des modes de réalisation susmentionnés ; des moyens de mesure du déséquilibre de ce dispositif.

Selon la présente invention, au moins un comparateur compare la valeur de déséquilibre dudit au moins un dispositif à un seuil, l'état de sortie du circuit de détection étant constitué à partir de la valeur de sortie de ce comparateur.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue en coupe schématique d'une portion de puce de circuit intégré ;
la figure 2, précédemment décrite, est une vue en coupe schématique de la portion de puce de la figure 1 après amincissement de son substrat ;
la figure 3 représente le schéma électrique d'un pont de Wheatstone ;
les figures 4A à 4C sont des vues de dessus et en coupe schématiques représentant un mode de réalisation de résistance ;
les figures 5 à 7 sont des vues de dessus schématiques de trois modes de réalisation d'un dispositif de détection d'amincissement du substrat d'une puce ;
les figures 8A à 8C sont des vues de dessus et en coupe schématiques représentant un mode de réalisation de résistance ; et
la figure 9 est une vue de dessus schématique représentant un autre mode de réalisation d'un dispositif de détection d'amincissement du substrat d'une puce.

### Description détaillée

Par souci de clarté, de mêmes éléments ont été désignés par de mêmes références aux différentes figures et, de plus, comme cela est habituel dans la représentation des circuits intégrés, les diverses vues en coupe et de dessus ne sont pas tracées à l'échelle.

La figure 3 représente le schéma électrique d'un pont de Wheatstone constitué de quatre résistances, par exemple de même valeur R. A une première diagonale du pont, entre des noeuds A et B, est appliquée une première tension V_{IN}. A une deuxième diagonale du pont, entre des noeuds C et D, apparaît une éventuelle tension de déséquilibre V_{OUT}.

Normalement, le pont de Wheatstone est équilibré et la tension de sortie V_{OUT} est indépendante de la valeur de V_{IN} et d'éventuelles variations de température, par exemple proche de 0 V.

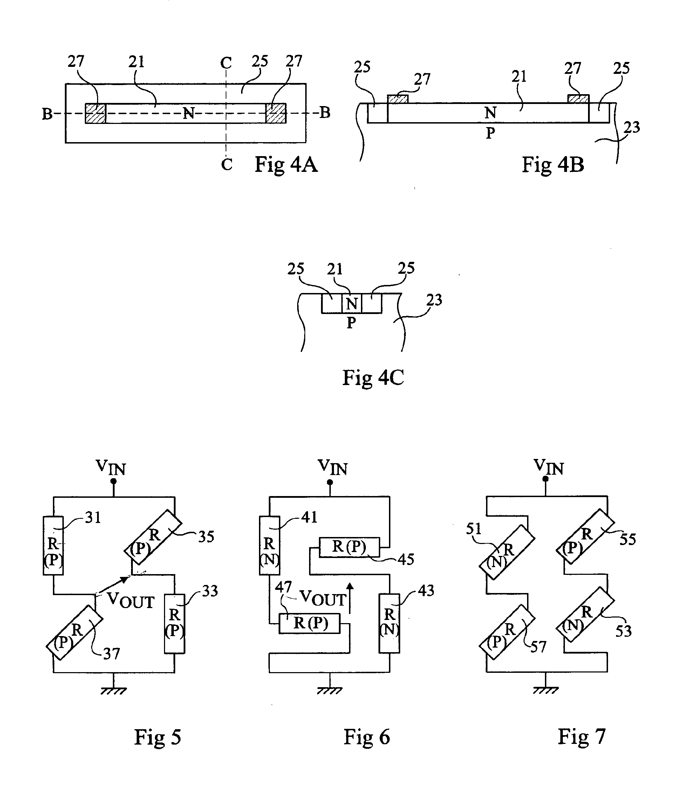

La figure 4A est une vue de dessus représentant de façon schématique un mode de réalisation d'une résistance diffusée. Les figures 4B et 4C sont des vues en coupe de la figure 4A selon les axes B-B et C-C. Une zone 21, dopée de type N, est formée, dans la partie supérieure d'une région 23 de substrat semiconducteur faiblement dopée de type P. En vue de dessus, la zone 21 a la forme d'un barreau rectangulaire. Une région d'oxyde 25 est disposée en périphérie de la zone 21 de façon à délimiter la résistance. Des plots conducteurs 27 sont disposés en contact avec les extrémités de la zone résistive 21. Tous les types de conductivité cités ci-dessus peuvent être inversés.

Le substrat semiconducteur, typiquement du silicium, a des propriétés piézorésistives, c'est-à-dire que sa conductibilité change en fonction des contraintes mécaniques auxquelles il est soumis. Or, l'amincissement du substrat précédant une attaque laser modifie les contraintes qui s'exercent dans la couche active de la puce. Par conséquent, la valeur de la résistance est susceptible de varier lorsque le substrat est aminci. Ainsi, pour détecter une variation d'épaisseur, on propose ici de détecter une variation de résistance.

La figure 5 est une vue de dessus schématique d'un mode de réalisation d'un dispositif de détection d'amincissement de substrat d'une puce. Ce dispositif, formé dans la couche active de la puce, comporte un pont de Wheatstone constitué de quatre résistances 31, 33, 35, 37, de même valeur R. Les résistances 31, 33, 35, 37, sont des résistances diffusées, formées dans un substrat semiconducteur de type P, de la façon décrite en relation avec les figures 4A à 4C. On considère ici un substrat de silicium monocristallin dont la face principale est dans un plan cristallin [001], c'est-à-dire un plan orthogonal à la direction cristalline (001). Les résistances opposées 31 et 33 sont parallèles entre elles et sont orientées, en notation de Miller, selon la direction (100). Les résistances opposées 35 et 37 sont parallèles entre elles et sont orientées selon la direction (110). Les résistances 31, 33, 35, 37 sont donc disposées dans le même plan [001], les directions (100) et (110) formant entre elles un angle de 45°.

Lorsque le substrat est aminci en vue d'une attaque laser, les variations de contrainte dans la couche active sont susceptibles d'affecter différemment des résistances orientées selon des directions différentes. Les résistances 31 et 33, orientées selon l'axe (100), restent sensiblement inchangées. Par contre, les résistances 35 et 37, orientées selon l'axe (110), subissent une variation importante. Ainsi, l'amincissement du substrat provoque une variation de la valeur de déséquilibre du pont. A titre d'exemple, la tension de sortie V_{OUT} du pont varie d'un facteur 4 lorsque 150 µm d'un substrat de 180 µm sont retirés (par exemple de 20 mV à 80 mV).

Si les quatre résistances étaient orientées selon la même direction, les variations de contrainte dans le substrat affecteraient toutes les résistances sensiblement de la même manière en cas d'amincissement du substrat. La valeur de déséquilibre du pont de Wheatstone resterait donc inchangée.

Si les résistances étaient formées dans un substrat semiconducteur de type N dont la face principale est également dans un plan [001], les résistances orientées selon une direction (110) resteraient sensiblement inchangées en cas d'amincissement du substrat. Par contre, les résistances orientées selon une direction (100) subiraient une variation importante. Ainsi, la valeur de déséquilibre du pont serait sensible à l'amincissement du substrat.

Il est en outre prévu des moyens, non représentés, de mesure de la valeur de déséquilibre du pont de Wheatstone. Selon un mode de réalisation, les moyens de mesure comportent des comparateurs comparant la tension V_{OUT} de sortie respectivement à un seuil positif, par exemple 50 mV et à un seuil négatif, par exemple 50 mV. Lorsque le déséquilibre du pont dépasse un seuil, la sortie du circuit de détection d'amincissement du substrat change, entrainant par exemple l'arrêt de la puce. On pourra par exemple choisir d'effectuer les mesures de tension de déséquilibre ponctuellement, à chaque démarrage de la puce, ou bien de façon continue, lorsque la puce est alimentée.

La figure 6 est une vue de dessus schématique d'une variante de réalisation d'un dispositif de détection d'amincissement du substrat d'une puce. Ce dispositif, formé dans la couche active de la puce, comporte un pont de Wheatstone constitué de quatre résistances 41, 43, 45, 47, de même valeur R. Les résistances 41, 43, 45, 47, sont des résistances diffusées, formées de la façon décrite en relation avec les figures 4A à 4C dans un substrat dont la face principale est dans un plan [001]. Les résistances opposées 41 et 43 sont formées dans une région du substrat faiblement dopée de type N. Les résistances 41 et 43 sont orientées, en notation de Miller, selon la direction (100). Les résistances opposées 45 et 47 sont formées dans une région du substrat faiblement dopée de type P. Les résistances 45 et 47 sont orientées selon la direction (010).

Lorsque le substrat est aminci en vue d'une attaque laser, les résistances 41 et 43, orientées selon la direction (100), subissent une variation importante. Par contre, les résistances 45 et 47, orientées selon la direction (010), restent sensiblement inchangées. Ainsi, l'amincissement du substrat provoque une variation de la valeur de déséquilibre du pont.

La figure 7 est une vue de dessus schématique d'une variante de réalisation d'un dispositif de détection d'amincissement de substrat d'une puce. Ce dispositif, formé dans la couche active de la puce, comporte un pont de Wheatstone constitué de quatre résistances 51, 53, 55, 57, de même valeur R. Les résistances 51, 53, 55, 57, sont des résistances diffusées, formées de la façon décrite en relation avec les figures 4A à 4C dans un substrat dont la face principale est dans un plan [001]. Les résistances opposées 51 et 53 sont formées dans une région du substrat faiblement dopée de type N. Les résistances opposées 55 et 57 sont formées dans une région du substrat faiblement dopée de type P. Les résistances 51, 53, 55 et 57 sont orientées selon la direction (010).

Lorsque le substrat est aminci en vue d'une attaque laser, les résistances 51 et 53 subissent une variation importante. Par contre, les résistances 55 et 57 restent sensiblement inchangées. Ainsi, l'amincissement du substrat provoque une variation de la valeur de déséquilibre du pont.

Bien entendu, l'invention ne se restreint pas aux configurations décrites en relation avec les figures 5 à 7. L'homme de l'art saura mettre en oeuvre le fonctionnement recherché en orientant différemment les résistances du pont de Wheatstone. Toutefois, pour obtenir de bonnes performances de détection, il faut que le pont ait une bonne sensibilité aux variations de contrainte engendrées par l'amincissement du substrat. De façon générale, des premières résistances opposées du pont doivent être particulièrement sensibles aux variations de contrainte entrainées par l'amincissement du substrat. Par contre, les secondes résistances opposées du pont doivent rester sensiblement inchangées lorsque le substrat est aminci. Les inventeurs ont déterminé que les configurations décrites ci-dessus présentent des performances de détection optimales pour un substrat de silicium [001]. Bien entendu, si la face principale du substrat n'est pas dans un plan [001], on choisira pour les résistances d'autres orientations fournissant une variabilité maximum en fonction des contraintes susceptibles d'être crées par un amincissement.

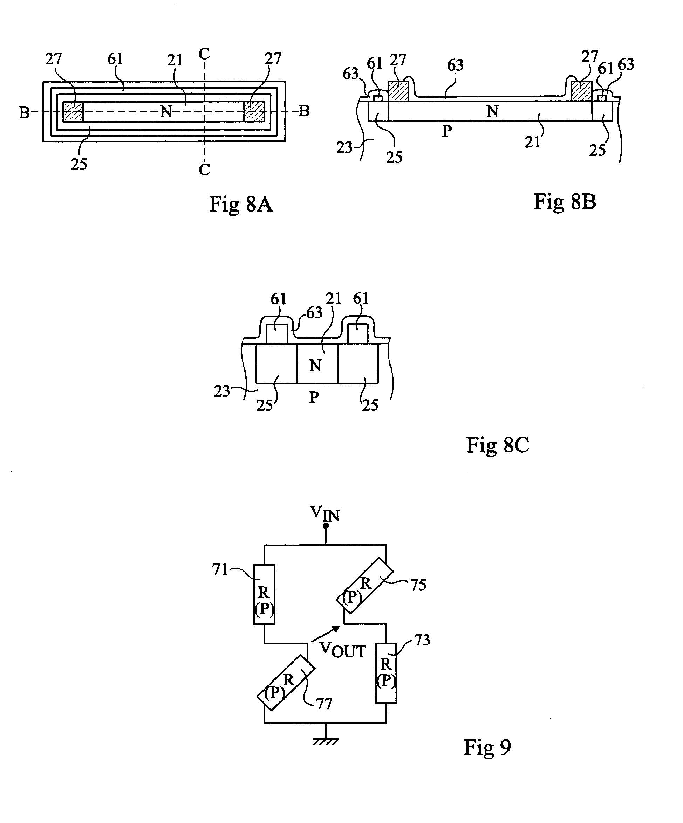

La figure 8A est une vue de dessus représentant de façon schématique un mode de réalisation d'une résistance diffusée, formée dans la couche active d'une puce. Les figures 8B et 8C sont des vues en coupe de la résistance de la figure 8A selon les axes B-B et C-C. La résistance des figures 8A à 8C est similaire à la résistance des figures 4A à 4C. Elle comporte en outre une couche de silicium polycristallin 61 sur la surface de la région isolante 25. Cette couche 61 correspond au maintien sur la région isolante 25 d'une portion d'une couche de silicium polycristallin isolée, formant à d'autres emplacements du circuit intégré des grilles isolées de transistors MOS. De plus, une couche de nitrure de protection 63 peut être maintenue, de façon à recouvrir l'ensemble de la résistance à l'exception des plots conducteurs 27.

La figure 9 est une vue de dessus schématique d'un dispositif de détection d'amincissement de substrat d'une puce. Ce dispositif comporte un pont de Wheatstone constitué de quatre résistances 71, 73, 75, 77, de même valeur R, formées dans un substrat semiconducteur de type P dont la face principale est dans un plan [001]. Les résistances opposées 71 et 73 sont des résistances diffusées, formées de la façon décrite en relation avec les figures 4A à 4C. Les résistances opposées 75 et 77 sont des résistances diffusées dont la région d'isolement est recouverte de silicium polycristallin, formées de la façon décrite en relation avec les figures 8A à 8C. Les résistances 71 et 73 sont orientées selon la direction (100). Les résistances de 75 et 77 sont orientées selon la direction (110).

Un tel dispositif offre des performances de détection d'amincissement du substrat améliorées par rapport au dispositif décrit en relation avec la figure 5. En effet, les couches de silicium polycristallin et de nitrure présentes dans les résistances 75 et 77 amplifient la sensibilité de ces résistances aux variations de contrainte dans la couche active.

Un avantage de l'utilisation des ponts de Wheatstone comme élément de détection d'amincissement réside dans le fait que la valeur de déséquilibre V_{OUT} est indépendante de la température du circuit. En effet, bien que les valeurs des résistances soient susceptibles de varier avec la température, la dérive subie est la même pour toutes les résistances d'un même pont, au moins dans le cas où toutes les résistances ont le même type de dopage. Ainsi, l'équilibrage reste inchangé.

Selon un avantage d'un mode de réalisation de l'invention, la solution proposée est compatible avec les procédés de fabrication usuels et ne nécessite pas d'étapes de fabrication supplémentaires.

Des modes de réalisation particuliers de la présente invention ont été décrits. Diverses variantes et modifications apparaîtront à l'homme de l'art. En particulier, la présente description mentionne un circuit de détection d'amincissement du substrat d'une puce comportant un pont de Wheatstone et des moyens de mesure du déséquilibre de ce pont. L'homme de l'art saura également mettre en oeuvre un circuit de détection comportant plusieurs ponts de Wheatstone. En outre, l'homme de l'art saura mettre en oeuvre le fonctionnement recherché quel que soit le type de conductivité du substrat semiconducteur dans lequel sont formées les résistances des ponts de Wheatstone. De plus, l'invention ne se retreint pas aux moyens de mesure de déséquilibre du pont exposés dans la présente description. L'homme de l'art saura mettre en oeuvre le fonctionnement recherché quels que soient les moyens de mesure de déséquilibre des ponts de Wheatstone employés. Par ailleurs, la présente description mentionne des ponts de Wheatstone constitués de quatre résistances de même valeur. L'homme de l'art saura mettre en oeuvre le fonctionnement recherché en utilisant des ponts de Wheatstone, normalement équilibrés, dans lesquels les résistances n'ont pas toutes la même valeur.

## Revendications

1. Circuit de détection d'amincissement du substrat (3) d'une puce de circuit intégré (1), comportant au moins un dispositif comportant, dans la couche active (5) du substrat (3), des résistances diffusées (31, 33, 35, 37) en forme de barreaux reliées en un pont de Wheatstone, dans lequel des premières résistances opposées (31, 33) du pont sont orientées selon une première direction, et les secondes résistances opposées (35, 37) du pont sont orientées selon une seconde direction,
dans lequel;
lesdites première et seconde directions sont choisies pour qu'un amincissement du substrat (3) entraine une variation de la valeur de déséquilibre (V_{OUT}) du pont ; et
ledit circuit de détection comporte au moins un comparateur comparant la valeur de déséquilibre (V_{OUT}) du pont à un seuil, l'état de sortie du circuit de détection étant constitué à partir de la valeur de sortie dudit au moins un comparateur, ledit état de sortie entrainant la mise en oeuvre de mesures de protection, d'aliénation, ou de destruction de données sensibles de la puce lorsque le déséquilibre du pont dépasse ledit seuil.

2. Circuit selon la revendication 1, dans lequel les faces principales du substrat sont dans le plan [001] de la structure cristalline du substrat.

3. Circuit selon la revendication 2, dans lequel :
lesdites résistances diffusées (31, 33, 35, 37) sont formées dans une région du substrat d'un premier type de conductivité ; et
lesdites première et seconde directions correspondent respectivement aux directions (100) et (110) de la structure cristalline du substrat.

4. Circuit selon la revendication 2, dans lequel :
lesdites premières résistances opposées (41, 43) sont formées dans une région du substrat d'un premier type de conductivité ;
lesdites secondes résistances opposées (45, 47) sont formées dans une région du substrat du second type de conductivité ; et
lesdites première et seconde directions correspondent respectivement aux directions (100) et (010) de la structure cristalline du substrat.

5. Circuit selon la revendication 2, dans lequel :
lesdites premières résistances opposées (51, 53) sont formées dans une région du substrat d'un premier type de conductivité ;
lesdites secondes résistances opposées (55, 57) sont formées dans une région du substrat du second type de conductivité ; et
lesdites première et seconde directions sont parallèles à la direction (110) de la structure cristalline du substrat.

6. Circuit selon la revendication 2, dans lequel :
lesdites résistances diffusées (71, 73, 75, 77) sont formées dans une région du substrat dopée de type P ;
lesdites première et seconde directions correspondent respectivement aux directions (100) et (110) de la structure cristalline du substrat ; et
lesdites secondes résistances opposées (75, 77) sont chacune entourées d'une région d'isolement recouverte d'une couche de silicium polycristallin, l'ensemble de la résistance étant recouvert d'une couche de nitrure de protection.

7. Circuit selon la revendication 2, dans lequel :
lesdites résistances diffusées (71, 73, 75, 77) sont formées dans une région du substrat dopée de type N ;
lesdites première et seconde directions correspondent respectivement aux directions (100) et (110) de la structure cristalline du substrat ; et
lesdites premières résistances opposées (71, 73) sont chacune entourées d'une région d'isolement recouverte d'une couche de silicium polycristallin, l'ensemble de la résistance étant recouvert d'une couche de nitrure de protection.

## Patentansprüche

1. Eine Schaltung zum Erkennen des Dünnerwerdens des Substrats (3) eines integrierten Schaltungschips (1), die Folgendes aufweist: stabförmige, diffundierte Widerstände (31, 33, 35, 37) in dem aktiven Gebiet (5) des Substrates (3), die als eine Wheatstone Brücke verbunden sind, wobei erste gegenüberliegende Widerstände (31, 33) der Brücke entlang einer ersten Richtung ausgerichtet sind, und die zweiten gegenüberliegenden Widerstände (35, 37) der Brücke entlang einer zweiten Richtung ausgerichtet sind;
wobei:
die ersten und zweiten Richtungen so sind, dass ein Dünnerwerden des Substrats (3) eine Änderung des Ungleichgewichtswertes (V_{OUT}) der Brücke verursacht; und
die Erkennungsschaltung mindestens einen Vergleicher bzw. Komperator aufweist, der den Ungleichgewichtswert (V_{OUT}) der Brücke mit einem Schwellenwert vergleicht, wobei der Ausgangszustand der Erkennungsschaltung auf dem Ausgangswert des mindestens einen Komperators basiert, wobei der Ausgangszustand die Umsetzung von Maßnahmen zum Schutz, Verfremden oder Zerstören von kritischen Daten des Chips verursacht, wenn das Brückenungleichgewicht den Schellenwert übersteigt.

2. Schaltung nach Anspruch 1, wobei die Hauptoberflächen des Substrates in Ebene [001] der Kristallstruktur des Substrates liegen.

3. Schaltung nach Anspruch 2, wobei:
die diffundierten Widerstände (31, 33, 35, 37) in einem Substratgebiet eines ersten Leitfähigkeitstyps gebildet sind; und
die ersten bzw. zweiten Richtungen den Richtungen (100) und (110) der Kristallstruktur des Substrats entsprechen.

4. Schaltung nach Anspruch 2, wobei:
die ersten gegenüberliegenden Widerstände (41, 43) in einem Substratgebiet eines ersten Leitfähigkeitstyps gebildet sind;
die zweiten gegenüberliegenden Widerstände (45, 47) in einem Substratgebiet eines zweiten Leitfähigkeitstyps gebildet sind; und
die ersten bzw. zweiten Richtungen den Richtungen (100) und (010) der Kristallstruktur des Substrats entsprechen.

5. Schaltung nach Anspruch 2, wobei:
die ersten gegenüberliegenden Widerstände (51, 53) in einem Substratgebiet eines ersten Leitfähigkeitstyps gebildet sind;
die zweiten gegenüberliegenden Widerstände (55, 57) in einem Substratgebiet eines zweiten Leitfähigkeitstyps gebildet sind; und
die ersten und zweiten Richtungen parallel zu der Richtung (110) der Kristallstruktur des Substrats liegen.

6. Schaltung nach Anspruch 2, wobei:
die diffundierten Widerstände (71, 73, 75, 77) in einem P-dotierten Substratgebiet gebildet sind;
die ersten bzw. zweiten Richtungen den Richtungen (100) und (110) der Kristallstruktur des Substrats entsprechen; und
die zweiten gegenüberliegenden Widerstände (75, 77) jeweils mit einem isolierenden Gebiet umgeben sind, dass mit einer Polysiliziumschicht bedeckt ist, wobei der gesamte Widerstand mit einer Nitridschutzschicht bedeckt ist.

7. Schaltung nach Anspruch 2, wobei:
die diffundierten Widerstände (71, 73, 75, 77) in einem N-dotierten Substratgebiet gebildet sind;
die ersten bzw. zweiten Richtungen den Richtungen (100) und (110) der Kristallstruktur des Substrats entsprechen; und
die ersten gegenüberliegenden Widerstände (71, 73) jeweils mit einem isolierenden Gebiet umgeben sind, dass mit einer Polysiliziumschicht bedeckt ist, wobei der gesamte Widerstand mit einer Nitridschutzschicht bedeckt ist.

## Claims

1. A circuit for detecting the thinning down of the substrate (3) of an integrated circuit chip (1), comprising, in the active area (5) of the substrate (3), bar-shaped diffused resistors (31, 33, 35, 37) connected as a Wheatstone bridge, wherein first opposite resistors (31, 33) of the bridge are oriented along a first direction, and the second opposite resistors (35, 37) of the bridge are oriented along a second direction;
wherein:
said first and second directions are such that a thinning down of the substrate (3) causes a variation of the imbalance value (V_{OUT}) of the bridge; and
said detection circuit comprises at least one comparator comparing the imbalance value (V_{OUT}) of the bridge with a threshold, the output state of the detection circuit being based on the output value of said at least one comparator, said output state causing the implementation of measures of protection, alienation or destruction of critical data of the chip when the bridge imbalance overcomes said threshold.

2. The circuit of claim 1, wherein the main surfaces of the substrate are in plane [001] of the crystal structure of the substrate.

3. The circuit of claim 2, wherein:
said diffused resistors (31, 33, 35, 37) are formed in a substrate region of a first conductivity type; and
said first and second directions respectively correspond to directions (100) and (110) of the crystal structure of the substrate.

4. The circuit of claim 2, wherein:
said first opposite resistors (41, 43) are formed in a substrate region of a first conductivity type;
said second opposite resistors (45, 47) are formed in a substrate region of the second conductivity type; and
said first and second directions respectively correspond to directions (100) and (010) of the crystal structure of the substrate.

5. The circuit of claim 2, wherein:
said first opposite resistors (51, 53) are formed in a substrate region of a first conductivity type;
said second opposite resistors (55, 57) are formed in a substrate region of the second conductivity type; and
said first and second directions are parallel to direction (110) of the crystal structure of the substrate.

6. The circuit of claim 2, wherein:
said diffused resistors (71, 73, 75, 77) are formed in a P-type doped substrate region;
said first and second directions respectively correspond to directions (100) and (110) of the crystal structure of the substrate; and
said second opposite resistors (75, 77) are each surrounded with an insulating region covered with a polysilicon layer, the entire resistor being covered with a protection nitride layer.

7. The circuit of claim 2, wherein:
said diffused resistors (71, 73, 75, 77) are formed in a N-type doped substrate region;
said first and second directions respectively correspond to directions (100) and (110) of the crystal structure of the substrate; and
said first opposite resistors (71, 73) are each surrounded with an insulating region covered with a polysilicon layer, the entire resistor being covered with a protection nitride layer.
